# EUROPEAN PATENT APPLICATION

(11) **EP 3 115 102 A1**
(43) Date of publication of application: **11.01.2017**
(21) Application number: 15759189.2
(22) Date of filing: 06.03.2015
(51) Int. Cl.: B01D 69/06, B01D 69/12, B01D 71/36, H01G 11/14, H01M 2/02, H01M 2/12, H05K 5/06

(54) **GAS-PERMEABLE MEMBER AND AIR-PERMEABLE CONTAINER**

(30) Priority: 06.03.2014 JP 2014044300; 13.02.2015 JP 2015026631
(71) Applicant: Nitto Denko Corporation, Ibaraki-shi, Osaka 567-8680 (JP)
(72) Inventor: ISHII, Kyouko, Ibaraki-shi Osaka 567-8680 (JP); FURUUCHI, Kouji, Ibaraki-shi Osaka 567-8680 (JP); YANO, Yozou, Ibaraki-shi Osaka 567-8680 (JP); FUKUOKA, Takahiro, Ibaraki-shi Osaka 567-8680 (JP); KIRA, Yoshiko, Ibaraki-shi Osaka 567-8680 (JP)
(74) Representative: Müller-Boré & Partner Patentanwälte PartG mbB
(86) International application number: PCT/JP2015/056697
(87) International publication number: WO 2015/133616

(57) **Abstract**

Provided is a gas permeable member including a gas permeable sheet configured to allow a gas to permeate therethrough; and a holder configured to hold the gas permeable sheet, wherein the gas permeable member is mounted in a container body having a surface on which a through hole communicating with an internal space is open by being inserted through the opening, so as to allow the gas to permeate therethrough between the internal space and the outer space of the container body via the gas permeable sheet, and the gas permeable member further includes a pressing part that contacts with an inner wall of the through hole and that presses the inner wall toward the open side at the contact position when a force is applied in a pull-out direction from the open side.

## Description

### CROSS-REFERENCE TO RELATED APPLICATION

This application claims priority to Japanese Patent Application Nos. 2014-44300 and 2015-26631, the disclosure of which is incorporated herein by reference in their entirety.

### FIELD

The present invention relates to a gas permeable member that allows a gas to selectively permeate therethrough, and to a gas permeable container including the gas permeable member.

### BACKGROUND

When gases are generated within a sealed container, the atmospheric pressure within the container increases, which may possibly result in damage or explosion of the container. For example, in electric storage devices such as secondary batteries, electrolytic capacitors, and electric double layer capacitors, a specific gas is generated during use within a container in which an electrode is housed, and therefore such a gas may possibly cause damage or explosion of the container if the gas is not discharged to the outside of the container. Therefore, various structures to discharge the gas within the container to the outside of the container have been proposed.

For example, as a container constituting an electric storage device, a container configured to house an electrode and an electrolyte, the container including a gas permeable part through which a gas permeates, thereby enabling circulation of the gas from inside to outside via the gas permeable part (hereinafter, referred to as a gas permeable container) has been proposed.

In such a gas permeable container, a gas permeable part is formed by mounting a gas permeable sheet through which a gas permeates on a through hole formed in a container body housing the electrode and the electrolyte so as to cover the through hole. Thus, the gas generated inside the gas permeable container is configured to permeate through the gas permeable part (specifically, the gas permeable sheet), so as to be discharged to the outside of the gas permeable container (see Patent Literatures 1 and 2).

The gas permeable sheet as described above is an exceptionally thin sheet and is very easily damaged. Further, if an impurity or the like is deposited on the surface of the gas permeable sheet, the gas permeability decreases. Therefore, the gas permeable sheet needs to be handled so as not to be contaminated. Accordingly, it is a very complicated operation to cut the gas permeable sheet into the size of the opening of the through hole or arrange it on the edge of the opening of the through hole while preventing damage and contamination.

Therefore, there is a gas permeable container in which a gas permeable member having a gas permeable sheet held by a holder is mounted in a through hole of such a container body as described above.

Examples of such a gas permeable member include a gas permeable member in which a gas flow hole that allows gas circulation is formed in a holder, and a gas permeable sheet is held to intersect the gas flow hole. The gas permeable member is inserted into the through hole of the container body to be mounted therein, so that the gas generated inside the gas permeable container is configured to be discharged to the outside of the container by permeating through the gas permeable sheet via the gas flow hole. Such a gas permeable member has the holder and the gas permeable sheet that are integrated together, and therefore the operation of mounting the gas permeable sheet in the container body can be easily carried out.

Meanwhile, the through hole generally needs only to allow gas permeation to an extent such that the pressure inside the gas permeable container does not cause damage or explosion of the container, and thus is set to have the minimum required size. Accordingly, there is a problem that, for example, in the case where the atmospheric pressure inside the container rapidly increases for any reason, high pressure is applied around the through hole, so that the gas permeable member easily separates from the through hole.

In order to firmly mount the gas permeable member in the through hole, it is conceivable to use an adhesive or the like, but adhesion with high strength is difficult. Further, in the case of mounting the gas permeable member in the container body using an adhesive or the like, a step of applying the adhesive onto the inner wall of the through hole or the outer surface of the holder is required, and thus the production operation becomes complicated.

### CITATION LIST

### Patent Literature

Patent Literature 1: WO 2009/1947 A
Patent Literature 2: Japanese Patent No. 4280014 A

### SUMMARY

### Technical Problem

It is therefore an object of the present invention to provide a gas permeable member which can facilitate mounting of a gas permeable sheet in a container body and which is comparatively difficult to separate from the container body.

It is another object of the present invention to provide a gas permeable container in which a gas permeable sheet can be easily mounted and in which a gas permeable member is comparatively difficult to separate from a container body.

### Solution to Problem

A gas permeable member according to the present invention includes: a gas permeable sheet configured to allow a gas to permeate therethrough; and a holder configured to hold the gas permeable sheet, wherein the gas permeable member is mounted in a container body having a surface on which a through hole communicating with an internal space is open by being inserted through the opening, so as to allow the gas to permeate therethrough between the internal space and the outer space of the container body via the gas permeable sheet, and the gas permeable member further includes a pressing part that contacts with an inner wall of the through hole and that presses the inner wall toward the open side at the contact position when a force is applied in a pull-out direction from the open side.

In the present invention, the configuration may be such that the pressing part is constituted by a pressing piece with one end side fixed to an outer surface of the holder and the other end side configured to press the inner wall, and the pressing piece is configured so that the other end side is arranged more on the open side within the through hole than the one end side.

In the present invention, the configuration may be such that a fixing member arranged on the open side of the holder is further provided, the pressing part is constituted by a pressing piece with one end side fixed to the outer surface of the fixing member and the other end side configured to press the inner wall, and the pressing piece is configured so that the other end side is arranged more on the open side within the through hole than the one end side.

The fixing member may include a locking member configured to be locked to the outer surface of the holder.

The gas permeable member may include an elastic part configured to bias the holder inside the through hole toward the open side by a recovering force due to elastic deformation.

A gas permeable container according to the present invention includes the aforementioned gas permeable member.

### BRIEF DESCRIPTION OF DRAWINGS

Fig. 1 is a partial sectional perspective view schematically showing a gas permeable member of the present embodiment.
Fig. 2 is a partial sectional view showing a gas permeable container of the present embodiment.
Fig. 3A is a partial sectional perspective view schematically showing a first member of a gas permeable member of another embodiment.
Fig. 3B is a partial sectional perspective view schematically showing a second member of the gas permeable member of the other embodiment.
Fig. 3C is a partial sectional perspective view schematically showing the gas permeable member of the other embodiment.
Fig. 4 is a perspective view schematically showing a gas permeable member of another embodiment.
Fig. 5 is a partial sectional perspective view showing a gas permeable container of the other embodiment.
Fig. 6 is a partial sectional perspective view schematically showing each member of a gas permeable member of another embodiment.
Fig. 7 is a perspective view schematically showing the gas permeable member of the other embodiment.
Fig. 8 is a partial sectional perspective view showing a gas permeable container of the other embodiment.
Fig. 9 is a partial sectional perspective view schematically showing each member of a gas permeable member of another embodiment.
Fig. 10 is a perspective view schematically showing the gas permeable member of the other embodiment.
Fig. 11 is a partial sectional perspective view showing a gas permeable container of the other embodiment.

### DESCRIPTION OF EMBODIMENTS

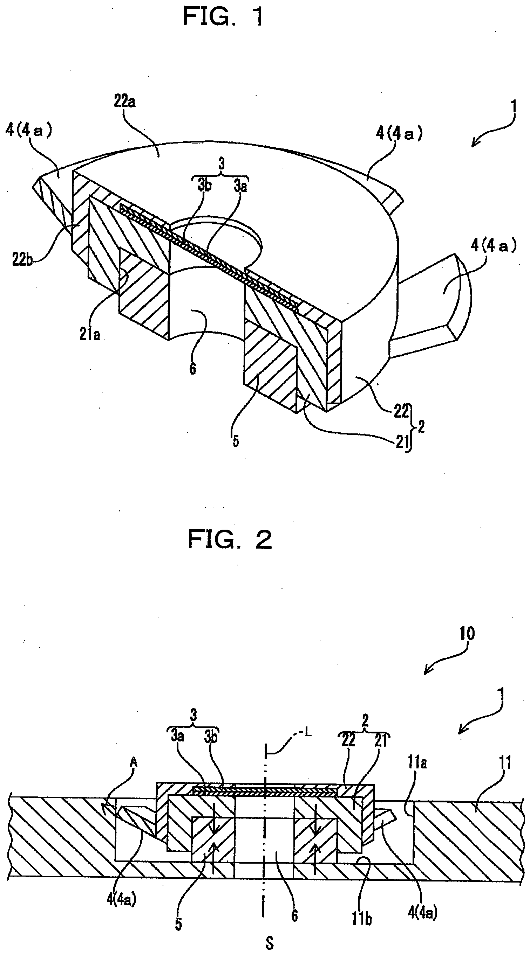

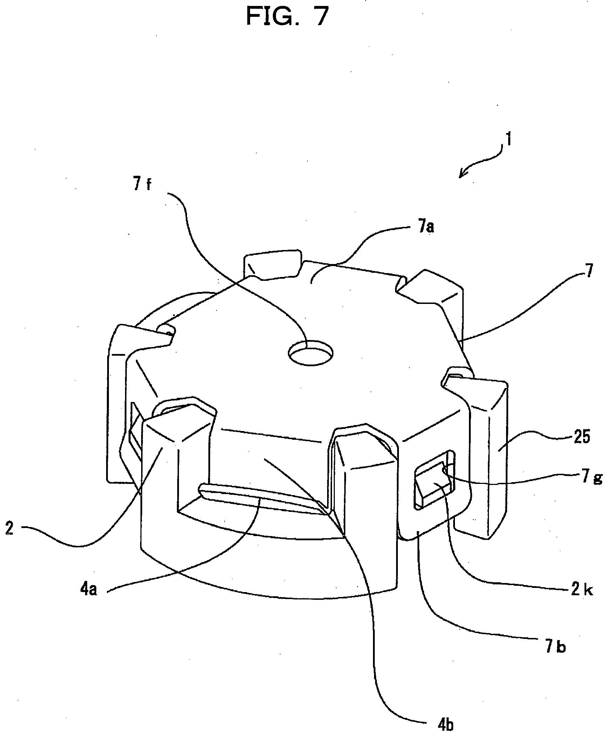

Hereinafter, embodiments of the present invention will be described with reference to Figs. 1 to 11. In the following drawings, the same or corresponding portions are denoted by the same reference numerals, and the description thereof is not repeated.

### First embodiment

As shown in Figs. 1 and 2, a gas permeable member 1 of the first embodiment includes: a gas permeable sheet 3 configured to allow a gas to permeate therethrough; and a holder 2 configured to hold the gas permeable sheet 3, wherein the gas permeable member 1 is mounted in a container body 11 having a surface on which a through hole 11a communicating with an internal space S is open by being inserted through the opening, so as to allow the gas to permeate therethrough between the internal space S and the outside of the container body 11 via the gas permeable sheet 3, and the gas permeable member 1 further includes a pressing part 4 that contacts with the inner wall of the through hole 11a and that presses the inner wall toward the open side at the contact position when a force is applied in the pull-out direction from the open side.

That is, the gas permeable member 1 includes the gas permeable sheet 3 configured to allow a gas to permeate therethrough, the holder 2 configured to hold the gas permeable sheet 3, and the pressing part 4.

The holder 2 is constituted by a first member 21, and a second member 22 coupled to the first member 21 so as to cover one end side of the first member 21. The first member 21 is a cylindrical member having a hole that is open at both ends. The second member 22 is constituted by a circular top plate 22a covering the end face on one end side of the first member 21, and a sidewall 22b provided extending from the circumferential edge of the top plate 22a toward the other end side so as to cover the lateral surface of the first member 21. At the center of the top plate 22a, a hole communicating with a hole of the first member 21 when the first member 21 and the second member 22 are coupled together is formed. That is, the hole of the first member 21 and the hole of the second member 22 constitute a part of a gas flow hole 6 of the holder 2 as described below.

The inner diameter of the sidewall 22b of the second member 22 is formed to be slightly larger than the outer diameter of the first member 21, and these two members are coupled together by the one end side of the first member 21 being fitted into the sidewall 22b of the second member 22.

In this embodiment, one end side of the holder 2 is on the open side when it is inserted into the through hole 11a of the container body 11 as described below, and the other end side of the holder 2 is arranged on the inner side that is opposite to the opening of the through hole 11a. Hereinafter, the one end side of the holder 2 will be referred to also as open side, and the other end side of the holder 2 will be referred to also as inner side.

Further, a line connecting the open side of the gas flow hole 6 of the holder 2 to the inner side passing through the center will be referred to as axis L.

Materials constituting the members of the holder 2 are not specifically limited, but examples thereof include metals such as aluminum and stainless steel, and synthetic resins such as phenol resin, PBT (Poly Butylene Terephtalate) resin, and PPS (Poly Phenylene Sulfide Resin) resin.

In particular, metals such as aluminum and stainless steel are preferable in view of heat resistance and chemical resistance.

The pressing part 4 is constituted by a plurality (6 in this embodiment) of pressing pieces 4a that are rectangular plate bodies mounted on the outer surface of the holder 2, that is, the outer circumferential surface of the sidewall 22b of the second member 22 in this embodiment, at specific intervals in the circumferential direction.

Specifically, the pressing pieces 4a of this embodiment have one end sides (one sides of the plate bodies) fixed to the outer circumferential surface of the second member 22 of the holder, and the tips that are the other end sides (the other sides of the plate bodies that are opposed to the one sides) arranged projecting outward from the circumferential edge of the top plate 22a of the second member 22.

Each of the pressing pieces 4a is arranged so as to have the tip inclined toward the open side of the holder 2 in side view. Specifically, as shown in Fig. 2, when the gas permeable member 1 is inserted into the through hole 11a of the container body 11, the pressing pieces 4a are mounted on the holder 2 so that the tips of the pressing pieces 4a are arranged inside the through hole 11a at positions closer to the open side than the one end sides.

Further, the pressing pieces 4a are configured so that, when the holder 2 is seen from the open side, the length of the longest line connecting the tip of one pressing piece 4a and the tip of another pressing piece 4a is slightly larger than the inner diameter of the through hole 11a of the container body 11 in which the gas permeable member 1 is mounted. That is, the pressing pieces 4a are configured so that, when the gas permeable member 1 is inserted through the opening of the through hole 11a of the container body 11, the inner wall of the through hole 11a contacts with the tips of the pressing pieces 4a, and the tips press the inner wall toward the open side at the contact positions.

The pressing piece 4a is configured so that, when a force is applied to the tip of the pressing piece 4a toward the center axis side of the holder 2, the angle between the pressing piece 4a and the outer circumferential surface of the holder 2 is reduced, that is, the other end of the pressing piece 4a is movable toward the outer circumferential surface of the holder 2. Further, when the force applied to the tip of the pressing piece 4a is released, the pressing piece 4a attempts to return to the original position.

As means for configuring the pressing piece 4a to be movable as above, the pressing piece 4a is made of a material having flexibility, for example.

Further, as means for configuring the pressing piece 4a to return to the original position as above, the pressing piece 4a is made of a material having some elasticity, for example.

The pressing pieces 4a of this embodiment are arranged on the outer circumferential surface of the sidewall 22b of the second member 22 of the holder 2 at specific intervals in the circumferential direction as described above, and therefore the pressing pieces 4a move toward the outer circumferential surface of the holder 2 when a force is applied to the tips of the pressing pieces 4a toward the center axis side of the holder 2.

Further, the pressing pieces 4a of this embodiment are mounted on the holder 2 by being integrally formed therewith. That is, the pressing pieces 4a are formed simultaneously with the holder 2 when the holder 2 is formed.

The gas permeable sheet 3 is arranged in a direction intersecting the axis L of the gas flow hole 6 of the holder 2. In this embodiment, the gas permeable sheet 3 is arranged at one end of the first member 21, that is, the end on the side that is covered by the second member 22, so as to cover the opening on the end side, and is held so as to be sandwiched between the first member 21 and the second member 22 of the holder 2.

The center of the gas permeable sheet 3 is exposed to the outside through the opening of the top plate 22a of the second member 22.

As the gas permeable sheet 3, a selective permeable sheet that allows a specific gas to selectively permeate therethrough or a non-selective permeable sheet without such selectivity for a specific gas can be mentioned.

In this embodiment, a plurality (specifically, 2) of pieces of the gas permeable sheet 3 are used, in which one is a selective permeable sheet 3a, and the other is a non-selective permeable sheet 3b.

The selective permeable sheet 3a is configured to be permeable selectively to a specific gas, thereby allowing the specific gas to flow from one surface side to the other surface side. The gas to which the selective permeable sheet 3a is permeable is not specifically limited, and examples thereof include gases such as hydrogen, carbon dioxide, and oxygen.

As the selective permeable sheet 3a having selectivity for hydrogen gas, the selective permeable sheet 3a constituted by a sheet material containing a resin such as aromatic polyimide or a sheet material containing layers of hydrogen-permeable metals (such as vanadium, vanadium alloy, palladium alloy, niobium, and niobium alloy) can be mentioned, for example. Examples of the sheet material containing hydrogen-permeable metal layers include a sheet material (metal foil) composed of a hydrogen-permeable metal layer and a sheet material formed by vapor deposition or the like of a metal layer on a substrate layer such as a resin sheet. As the selective permeable sheet 3a that allows carbon dioxide to selectively permeate therethrough, the selective permeable sheet 3a composed of a sheet material made of silicone rubber, a PVA (polyvinyl alcohol) crosslinked sheet material, a PEG (polyethylene glycol) crosslinked sheet material, or the like can be mentioned.

The non-selective permeable sheet 3b is arranged on at least one surface side of the selective permeable sheet 3a to overlap the selective permeable sheet 3a. The non-selective permeable sheet 3b can be appropriately selected depending on the properties, etc., of the selective permeable sheet 3a to be laminated, but examples thereof include the non-selective permeable sheet 3b composed of a sheet material such as a porous film made of polytetrafluoroethylene (PTFE), ceramic, metal, resin, or the like. In particular, a porous film made of PTFE is preferable as a sheet material constituting the non-selective permeable sheet 3b because of its high water repellency, high heat resistance, and high chemical resistance.

The gas permeable member 1 of this embodiment includes an elastic part configured to bias the holder 2 inside the through hole 11a of the container body 11 toward the open side of the container body 11 by a recovering force due to elastic deformation.

The elastic part of this embodiment is constituted by a rubber member 5 fitted into a recess 21a formed at the end on the inner side of the first member 21 of the holder 2.

The rubber member 5 has an annular shape with a hole formed at the center, and is fitted into the recess 21a formed at the other end of the first member 21 of the holder 2 so that the aforementioned hole communicates with the hole of the first member 21 of the holder 2.

That is, the rubber member 5 is fitted into the holder 2, thereby constituting the gas flow hole 6 of the gas permeable member 1 by the holes of the first member 21 and the second member 22 of the holder 2 and the hole of the rubber member 5.

The rubber member 5 can be compressed in the direction of the axis L of the holder 2. Further, the rubber member 5 is formed to have a thickness so as to slightly project from the surface at the end on the inner side of the holder 2 toward the inner side.

Next, a gas permeable container 10 of this embodiment including the gas permeable member 1 as described above will be described.

The gas permeable container 10 of this embodiment includes the container body 11 having a surface on which the through hole 11a communicating with the internal space S is open.

The through hole 11a of the container body 11 is formed into a shape such that the opening on the inner side of the container body 11 has a smaller diameter than the opening on the outer side of the container body 11.

The opening on the inner side of the through hole 11a has a diameter that almost coincides with the inner diameter of the hole of the rubber member 5, and the upper circumferential edge of the opening on the inner side is formed as a bottom 11b of the through hole 11a on which the rubber member 5 can be arranged.

The gas permeable container 10 is used for housing an electrode or the like, for example, as a member constituting an electric storage device such as a secondary battery, an electrolytic capacitor (aluminum electrolytic capacitor, etc.), and an electric double layer capacitor.

In the case where the gas permeable container 10 is such an electric storage device member, various gases are generated inside the gas permeable container body 11. For example, in the case where the gas permeable container 10 is used as a container constituting an aluminum electrolytic capacitor, hydrogen gas is generated. In the case where it is used as a container constituting an electric double layer capacitor, carbon dioxide gas is generated.

Therefore, it is preferable to select a material constituting the selective permeable sheet 3a corresponding to the type of gas generated within the gas permeable container 10.

The gas permeable member 1 is mounted in the container body 11 by being inserted through the opening on the surface of the container body 11 with the inner side of the holder 2, that is, the side to which the rubber member 5 constituting the elastic part is fitted being first inserted.

The pressing pieces 4a of the gas permeable member 1 are configured so that the tips of the pressing pieces 4a are movable toward the outer circumferential surface side of the holder 2, and the length of the diagonal line connecting the tip of one pressing piece 4a to the tip of another pressing piece 4a is set to be slightly larger than the inner diameter of the through hole 11a of the container body 11. Accordingly, when the gas permeable member 1 is inserted into the through hole 11a of the container body 11, the tips of the pressing pieces 4a are pressed by the inner wall of the through hole 11a toward the center axis side of the holder 2. In this case, the tips of the pressing pieces 4a are configured to move toward the outer circumferential surface side of the holder 2, and therefore when the gas permeable member 1 is inserted into the through hole 11a, the insertion can be performed without interference of the pressing pieces 4a. After the gas permeable member 1 is inserted into the through hole 11a, the pressing pieces 4a attempt to return to the original positions, and thus the pressing pieces 4a press the inner wall of the through hole 11a.

Further, when the open side of the container body 11 is referred to as the upper side and the inner side thereof is referred to as the lower side, the tips of the pressing pieces 4a are arranged inclined upwardly in the through hole 11a. Therefore, the gas permeable member 1 is arranged within the through hole 11a while the tips of the pressing pieces 4a press the inner wall of the through hole 11a obliquely upwardly, that is, toward the open side (toward the direction shown by the arrow A in Fig. 2) at the contact positions.

Further, the rubber member 5 is fitted into the other end of the gas permeable member 1 so as to slightly project from the end of the holder 2 toward the inner side.

Therefore, while the rubber member 5 is arranged at the bottom 11b of the through hole of the container body 11, the gas permeable member 1 is further inserted from the open side, and thereby the rubber member 5 is compressed.

The elastic part of this embodiment is arranged at the bottom 11b of the through hole 11a while the rubber member 5 is compressed, and therefore the sealing properties to the bottom 11b of the through hole 11a are enhanced.

As described above, in the gas permeable container 10 in which the gas permeable member 1 is mounted in the through hole 11a of the container body 11, the gas permeable member 1 can be fixed to the container body 11 while the gas permeable member 1 is locked by the friction between the pressing part 4 and the inner wall of the through hole 11a. Therefore, the gas permeable member 1 is made difficult to separate by the pressing force of the pressing part 4 against the inner wall of the through hole.

Further, in the gas permeable container 10, the gas permeable member 1 biases the holder toward the open side by the recovering force due to elastic deformation of the rubber member 5.

Meanwhile, the pressing part 4 presses the inner wall of the through hole 11a toward the open side, that is, obliquely upwardly at the contact position with the inner wall. Accordingly, the force of the pressing part 4 pressing the inner wall of the through hole 11a is increased by the force of the rubber member 5 from the inner side to the open side of the container body, and the gas permeable member 1 can be mounted in the container body 11 while being more strongly fixed by the pressing part 4, so that the gas permeable member 1 is further difficult to separate from the container body 11.

Further, in the gas permeable member 1 of this embodiment, the gas permeable sheet 3 is mounted on the holder 2, as described above, and therefore the gas permeable sheet 3 can be arranged on the through hole 11a of the container body 11 merely by inserting the gas permeable member 1.

The gas permeable container 10 as described above may be used for housing an electrode or the like, for example, as a member constituting an electric storage device such as a secondary battery, an electrolytic capacitor (aluminum electrolytic capacitor, etc.), and an electric double layer capacitor, in some cases. In such a case, various gases are generated inside the gas permeable container 10. For example, in the case where the gas permeable container 10 is used as a container constituting an aluminum electrolytic capacitor, hydrogen gas is generated. In the case where it is used as a container constituting an electric double layer capacitor, carbon dioxide gas is generated. Therefore, a specific gas can be discharged to the outside of the gas permeable container 10 by selecting a material constituting the selective permeable sheet 3a corresponding to the type of gas generated within the gas permeable container 10.

### Second embodiment

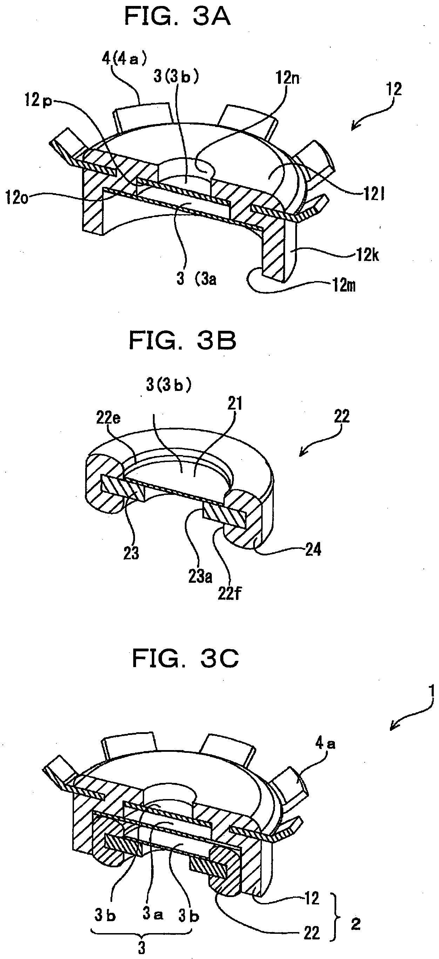

As shown in Fig. 3, in the gas permeable member 1 of the second embodiment, the holder 2 is constituted by a first member 12 and the second member 22 that can be fitted together.

In the first member 12 of this embodiment, the selective permeable sheet 3a and the non-selective permeable sheet 3b are mounted as the gas permeable sheet 3.

Specifically, the first member 12 includes a sidewall 12k that is a cylindrical body, and a top plate 121 arranged on one end side of the sidewall 12k. On the other end side of the sidewall 12k, an opening 12m is formed.

The top plate 121 is formed into an annular shape in top view, and an opening 12n communicating with the inside of the sidewall 12k is formed at the center of the top plate 121. That is, a gas permeable path through which a gas flows along the axial direction of the sidewall 12k is formed in the first member 12 by the opening 12n of the top plate 121, the inner circumferential surface of the sidewall 12k, and the opening 12m on the other side of the sidewall 12k.

The gas permeable path is formed so that its sectional shape that is orthogonal to the axial direction (that is, the circulation direction of the gas flowing thereinside) stepwisely increases from one end side (the top plate 121 side) to the other end side (the opening 12m side).

The first member 12 of this embodiment includes sheet mounting parts 12o and 12p at two places inside the sidewall 12k. The sheet mounting parts 12o and 12p have an annular shape extending from the inner circumferential surface of the sidewall 12k toward the center side of the gas permeable path. The selective permeable sheet 3a is mounted on the sheet mounting part 12o formed on the other end side (the opening 12m side), and the non-selective permeable sheet 3b is mounted on the sheet mounting part 12p formed on the one end side (the top plate 121 side).

The first member 12 of this embodiment includes a plurality (8 in this embodiment) of the pressing pieces 4a radially projecting in the radial direction from the outer circumferential edge of the top plate 121 around the connection between the sidewall 12k and the top plate 121.

The pressing pieces 4a are mounted inclined to a surface orthogonal to the axis of the sidewall 12k (the center axis of the cylindrical body constituting the sidewall 12k).

In the gas permeable member 1 of this embodiment, members formed as separate bodies from the first member 12 are mounted on the first member 12 as the pressing pieces 4a. Examples of means for mounting the pressing pieces 4a on the first member 12 include welding and adhesion.

The second member 22 of this embodiment includes a frame 24 that is a cylindrical body, the gas permeable sheet 3 the circumferential edge of which is supported by the frame 24, and a fixing plate 23 which is stacked on one surface side of the gas permeable sheet 3 and the circumferential edge of which is supported by the frame 24 together with the gas permeable sheet 3. The fixing plate 23 has an opening 23a at the center.

The one surface side of the gas permeable sheet 3 is exposed through the opening 23a of the fixing plate 23 and an opening 22e on one end side of the frame 24, and the other surface side of the gas permeable sheet 3 is exposed through an opening 22f on the other end side of the frame 24 and the opening 23a of the fixing plate 23.

That is, in the second member 22, a gas permeable path is formed by the openings of the frame 24 and the opening of the fixing plate 23.

The gas permeable sheet 3 mounted on the second member 22 of this embodiment is the non-selective permeable sheet 3b.

The material for the frame 24 of this embodiment is not specifically limited, but an elastic body such as silicone rubber and EPDM (Ethylene Propylene Rubber) is preferable because of good sealing properties to the first member 12.

As shown in Fig. 3C, the gas permeable member 1 of this embodiment is integrally mounted by fitting the second member 22 into the first member 21.

Specifically, the second member 22 is inserted through the opening 12m on the other side of the first member 12 to be fitted thereto. At this time, the second member 22 is arranged so that the fixing plate 23 of the second member 22 is arranged on the outer side.

Further, when the gas permeable member 1 of this embodiment is mounted in the gas permeable container, it is preferably arranged in the container body so that the side of the gas permeable member 1 on which the second member 22 is fitted is located on the side closer to the inside of the container body.

In this case, the gas permeable sheet 3 (the non-selective permeable sheet 3b) of the second member 22 is arranged on the side closer to the inside of the container body.

In the gas permeable member 1 of this embodiment, the gas permeable sheet 3 of the second member 22 can be inspected separately from the gas permeable sheet 3 of the first member 12 before being accomplished as the gas permeable member 1, and therefore the function of the gas permeable sheet 3 of the second member 22 can be reliably checked.

### Third embodiment

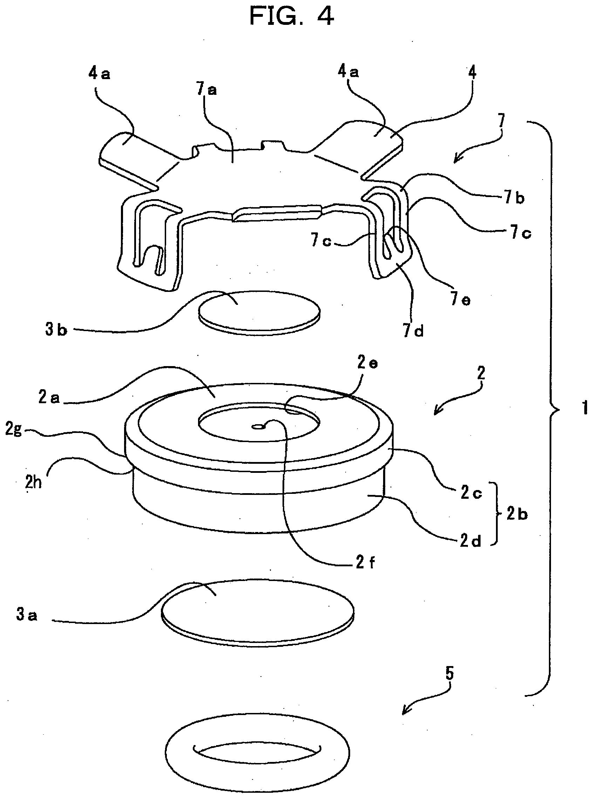

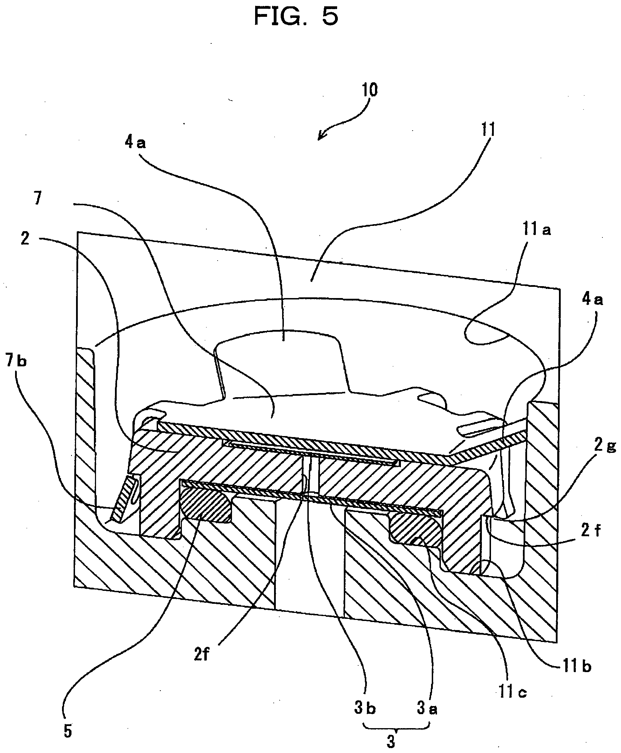

As shown in Figs. 4 and 5, the gas permeable member 1 of the third embodiment further includes a fixing member 7 arranged on the open side of the holder 2, and the pressing part 4 is mounted on the fixing member 7.

Specifically, the gas permeable member 1 of this embodiment includes the fixing member 7 arranged on the open side of the holder 2, the pressing part 4 is constituted by the pressing pieces 4a with one end sides fixed to the outer surface of the fixing member 7 and the other end sides configured to press the inner wall of the through hole 11a of the container body 11, and the pressing pieces 4a are configured so that the other end sides are arranged more on the open side in the through hole 11a than the one end sides.

The holder 2 of this embodiment includes a circular top plate 2a and a cylindrical sidewall 2b provided extending from the circumferential edge of the top plate 2a, a sheet mounting part 2e constituted by a circular recess in which the circular gas permeable sheet 3 can be arranged is formed at the center of the upper surface of the top plate 22a, and a hole 2f passing through the top plate 2a in the thickness direction is formed at the center of the sheet mounting part 2e.

A step 2g is formed along the circumferential direction on the outer circumferential surface of the sidewall 2b. Specifically, one end side (top plate side) of the sidewall 2b is formed as a large-diameter part 2c having substantially the same outer diameter as the diameter of the top plate 2a, the other end side of the sidewall 2b is formed as a small-diameter part 2d having a smaller outer diameter than the large-diameter part 2c, and the step 2g is formed between the large-diameter part 2c and the small-diameter part 2d. The step 2g includes a lower surface 2h parallel to the upper surface of the top plate 2a, and the lower surface 2h is formed to project outwardly along the circumferential direction of the sidewall 2b.

The fixing member 7 of this embodiment includes a fixing plate 7a in the form of a plate that can be arranged on the upper surface side (that is, a surface side that is arranged on the open side when the gas permeable member 1 is arranged in the container body 11) of the top plate 2a, the pressing pieces 4a arranged as the pressing part 4 to project obliquely upwardly (to the open side) from a plurality of points (3 points in this embodiment) in the circumferential direction of the circumferential edge of the fixing plate 7a, and locking members 7b arranged to project downwardly from a plurality of places (3 places in this embodiment), at which the pressing pieces 4a are not arranged, in the circumferential direction of the circumferential edge of the fixing plate 7a.

Also in this embodiment, when the gas permeable member 1 is arranged in the through hole 11a of the container body 11, the open side is referred to as the upper side, and the inner side of the container body 11 is referred to as the lower side.

The locking members 7b of this embodiment can be locked on the outer surface of the holder 2. More specifically, each of the locking members 7b includes a pair of fixing pieces 7c arranged in the vertical direction so as to abut the outer surface of the sidewall 2b from the large-diameter part 2c to the small-diameter part 2d when the fixing plate 7a is arranged in contact with the upper surface of the top plate 2a of the holder 2, a coupling member 7d configured to couple the lower ends of the pair of fixing pieces 7c to each other, and a locking projection 7e arranged to project upwardly from the coupling member 7d.

The coupling member 7d is arranged to project outwardly (in a direction away from the sidewall 2b) and obliquely downwardly from the lower ends of the pair of fixing pieces 7c.

The locking projection 7e is arranged to project slightly inwardly (in a direction toward the sidewall 2b) and obliquely upwardly from the center of the coupling member 7d.

The tip of the locking projection 7e is arranged at a position so as to abut the lower surface 2h of the step 2g of the holder 2 when the fixing plate 7a is arranged on the upper surface side of the top plate 2a of the holder 2.

The fixing member 7 of this embodiment is configured so that a slight gap is formed between the upper surface of the top plate 2a and the lower surface of the fixing plate 7a when the fixing member 7 is mounted on the holder 2 by abutting the locking projection 7e against the lower surface 2h of the step 2g of the holder 2.

The material constituting the fixing member 7 is not specifically limited, but examples thereof include the same metals and synthetic resins as for the holder 2.

In particular, the pressing pieces 4a and the locking members 7b are preferably made of materials having flexibility and elasticity such that the pressing pieces 4a and the locking members 7b can be inserted into the through hole 11a while they deform to some extent when the gas permeable member 1 is inserted into the through hole 11a of the container body 11, as described below, and they attempt to return to the original positions after the insertion.

In the fixing member 7 of this embodiment, the fixing plate 7a, the pressing pieces 4a, and the locking members 7b may be integrally formed by integral molding or the like, or members for the pressing pieces 4a and the locking members 7b that are formed as separate bodies from the fixing plate 7a may be mounted on the fixing plate 7a by mounting means such as welding and adhesion.

The fixing member 7 may be formed, for example, by die-cutting a plate body such as a metal plate into a specific shape in which parts to serve as pressing pieces, locking members, and fixing plates are continuous, forming through holes at places to serve as the locking members into a shape such that fixing pieces, coupling members, and locking projections are formed, and folding them at specific positions, when forming the fixing plate 7a, the pressing pieces 4a, and the locking members 7b.

The elastic part 5 of this embodiment is constituted by the rubber member 5 fitted into the inner side of the holder 2. The rubber member 5 has an annular shape with a hole formed at the center.

In this embodiment, the selective permeable sheet 3a and the non-selective permeable sheet 3b are mounted as the gas permeable sheet 3.

In the gas permeable member 1 of this embodiment, the non-selective permeable sheet 3b is arranged on the sheet mounting part 2e on the upper surface of the top plate 2a of the holder 2, and the selective permeable sheet 3a is arranged on the surface (referred to also as lower surface) opposed to the upper surface of the top plate 2a.

The upper surface of the non-selective permeable sheet 3b arranged on the upper surface of the top plate 2a is fixed by the fixing plate 7a of the fixing member 7.

The circumferential edge of the lower surface of the selective permeable sheet 3a arranged on the lower surface of the top plate 2a is fixed by the rubber member 5. That is, the gas permeable member 1 is configured so that the openings at both ends in the vertical direction of the hole 2f of the holder 2 are closed by the selective permeable sheet 3a and the non-selective permeable sheet 3b.

The selective permeable sheet 3a and the non-selective permeable sheet 3b may be mounted on the holder 2 by adhesion or the like, or may be held by being sandwiched between the holder 2 and the fixing member 7 or the rubber member 5.

The gas permeable member 1 of this embodiment as described above constitutes the gas permeable container 10 by being mounted in the through hole 11a of the container body 1 as in the above-described embodiments.

As shown in Fig. 5, the bottom 11b is formed in the through hole 11a of the container body 11 of this embodiment as in the container body 11 of the first embodiment. Further, an annular step 11c in which the rubber member 5 is arranged is formed at the center of the bottom 11b.

The holder 2, the gas permeable sheet 3, the fixing member 7, and the rubber member 5 may be integrally mounted as the gas permeable member 1 of this embodiment before being mounted on the container body 11.

For example, the members of the gas permeable member 1 are integrally formed by first mounting the non-selective permeable sheet 3b on the sheet mounting part 2e on the upper surface of the top plate 2a of the holder 2 by welding such as heat welding and ultrasonic welding, adhesion or the like, then, after arranging the selective permeable sheet 3a on the inner side of the holder 2, fitting the rubber member 5 thereto, further putting the fixing member 7 from the top plate 2a side of the holder 2 to cover the holder 2, and locking the locking members 7b on the lower surface 2h of the step 2g on the sidewall 2b of the holder 2.

In this way, the gas permeable member 1 can be easily mounted in the container body 11 by integrally forming the members of the gas permeable member 1.

When the gas permeable member 1 is mounted in the through hole 11a the sealing properties between the gas permeable member 1 and the through hole 11a can be enhanced by arranging the rubber member 5 on the step 11c in a compressed state. Further, the holder 2 is biased toward the open side by the recovering force due to elastic deformation of the compressed rubber member 5.

In the gas permeable container 10 of this embodiment, the fixing member 7 of the gas permeable member 1 is arranged closest to the open side of the container body 1. The fixing member 7 includes the pressing pieces 4a as in the first embodiment. As described above, in the case where the fixing member 7 is made of a material having flexibility and elasticity to some extent, the pressing pieces 4a are deformed by the inner wall of the through hole 11a when the gas permeable member 1 is inserted into the through hole 11a of the container body 11, and therefore the fixing member 7 can be inserted into the through hole 11a without interference of the pressing pieces 4a.

Further, after the gas permeable member 1 is inserted into the through hole 11a, the pressing pieces 4a press the inner wall of the through hole 11a due to the force of the pressing pieces 4a attempting to return to the original positions, and thus the gas permeable member 1 can be fixed to the container body 11 while the gas permeable member 1 is locked by the friction of the pressing pieces 4a against the inner wall of the through hole 11a. Therefore, separation of the gas permeable member 1 can be made difficult by the pressing force of the pressing part 4 against the inner wall of the through hole.

Further, the gas permeable member 1 of this embodiment includes the fixing member 7, and the fixing member 7 includes the locking members 7b. Each of the locking members 7b includes the locking projection 7e, and the tip of the locking projection 7e is arranged at a position so as to abut the step 2g of the holder 2 when the fixing plate 7a is arranged on the upper surface side of the top plate 2a of the holder 2. As described above, in the case where the fixing member 7 is made of a material having flexibility and elasticity to some extent, the fixing member 7 can be mounted on the holder 2 with the locking projection 7e deforming along the surface of the sidewall 2b of the holder 2.

In the holder 2 of this embodiment, the large-diameter part 2c having substantially the same outer diameter as the diameter of the top plate 2a and the small-diameter part 2d having a smaller outer diameter than the large-diameter part 2c are formed, and the step 2g is formed between the large-diameter part 2c and the small-diameter part 2d. Accordingly, when the fixing member 7 is inserted in the depth direction through the opening of the through hole 11a of the container body 11, and the locking projection 7e is arranged below the small-diameter part 2d, the locking projection 7e abuts the lower surface 2h of the step 2g, and the locking projection 7e is locked by the lower surface 2h of the step 2g, so that separation of the fixing member 7 from the container body 11 is made more difficult, even if a force is applied in the pull-out direction from the open side.

Further, the fixing plate 7a of the fixing member 7 of this embodiment is configured so that a slight gap is formed between the upper surface of the top plate 2a and the lower surface of the fixing plate 7a when the fixing member 7 is mounted on the holder 2 by abutting the locking projection 7e against the lower surface 2h of the step 2g of the holder 2. Accordingly, when the gas inside the container body 11 is discharged to the outer space of the container body 11 through the hole 2f of the holder 2, the gas can pass through the gap.

### Fourth embodiment

This embodiment is a modification of the above-described third embodiment.

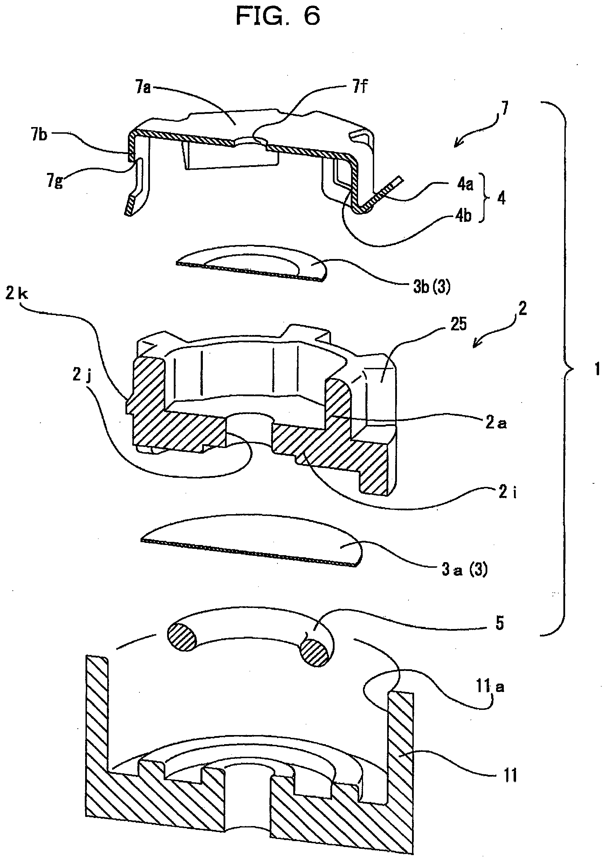

As shown in Figs. 6 to 8, the sidewall 2a of the holder 2 of this embodiment is a hexagonal cylindrical body. That is, the sidewall 2a of this embodiment is six-sided, and partition walls 25 projecting outwardly are arranged between adjacent sides of the sidewall 2a. Further, projections 2k are formed at the centers of alternately arranged three sides of the six sides of the sidewall 2a. The lower parts of three sides in which the projections 2k are not formed are configured to project throughout the circumference so as to couple the partition walls 25, and portions of the three sides that are surrounded by the projecting lower parts and the partition walls 25 are formed as portions in which the pressing pieces 4a are arranged, which will be described below.

A bottom plate 2i is arranged on the lower end side of the holder 2 so as to close the lower opening of the sidewall 2a.

The bottom plate 2i is a hexagonal plate body in bottom view, and a through hole 2j is formed at the center.

The upper end side of the holder 2 is open.

The fixing plate 7a of the fixing member 7 of this embodiment is a hexagonal plate body in top view, and the locking members 7b capable of being locked to the pressing part 4 and the holder 2 are arranged to project downwardly from the six sides constituting the circumferential edge of the plate body.

In this embodiment, three pieces of each of the pressing part 4 and the locking members 7b are alternately arranged on the six sides of the fixing plate 7a. Further, a through hole 7f is formed at the center of the fixing plate 7a.

The pressing part 4 of this embodiment is constituted by support pieces 4b projecting downwardly from the respective sides of the fixing plate 7a, and the pressing pieces 4a projecting obliquely upwardly so that one end sides are fixed to the lower ends of the support pieces 4b, and the other end sides press the inner wall.

The locking members 7b are arranged to project downwardly from the respective sides (sides adjacent to the respective sides on which the support pieces 4b are arranged) of the fixing plate 7a, and through holes 7g are formed at the respective centers of the locking members 7b.

The fixing member 7 of this embodiment is arranged so that the fixing plate 7a closes the opening on the upper end side of the holder 2. At this time, the fixing member 7 is mounted on the holder 2 so that the locking members 7b are arranged on the outer side of the sidewall 2b on which the projections 2k are formed.

The locking members 7b are locked to the sidewall 2a by fitting the projections 2k on the sidewall 2a into the through holes 7g of the locking members 7b, so that the fixing member 7 and the holder 2 are fixed to each other.

Further, the pressing part 4 and the locking members 7b are alternately arranged on the outer side of the sidewall 2a, with the partition walls 25 interposed therebetween. That is, the fixing member 7 is mounted on the holder 2 so that the partition walls 25 mesh with the pressing part 4 and the locking members 7b.

Accordingly, the fixing member 7 of this embodiment is comparatively firmly mounted on the holder 2.

In the gas permeable member 1 of this embodiment, 2 pieces of the gas permeable sheet 3 are arranged to close the openings at the upper and lower ends of the holder 2. Specifically, the non-selective permeable sheet 3b is arranged above the opening on the upper end side of the holder 2 and is fixed by the lower surface of the fixing plate 7a of the fixing member 7.

The selective permeable sheet 3a is arranged on the lower surface side of the bottom plate 2i of the holder 2 so as to close the through hole 2j.

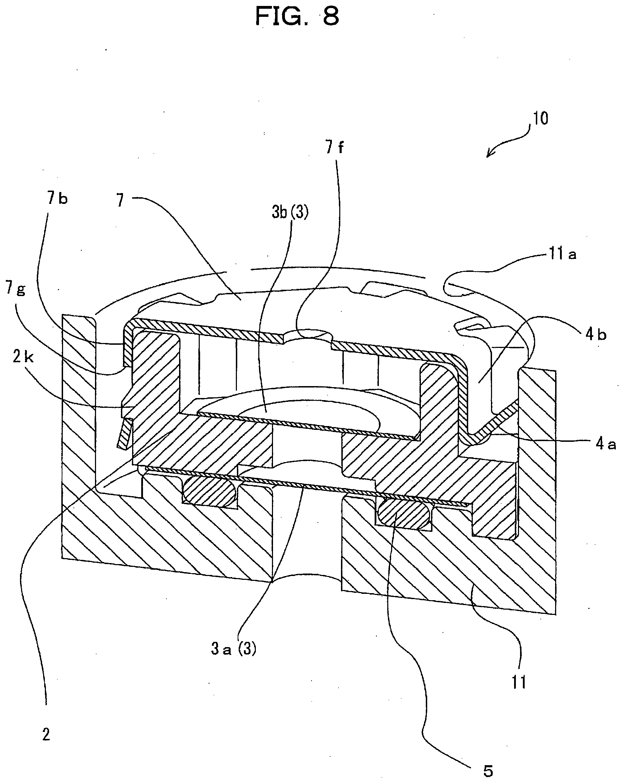

The gas permeable container 10 can be achieved by inserting the gas permeable member 1 of this embodiment as described above into the opening of the container body 11, as shown in Fig. 8.

### Fifth embodiment

This embodiment is a modification of the above-described third embodiment.

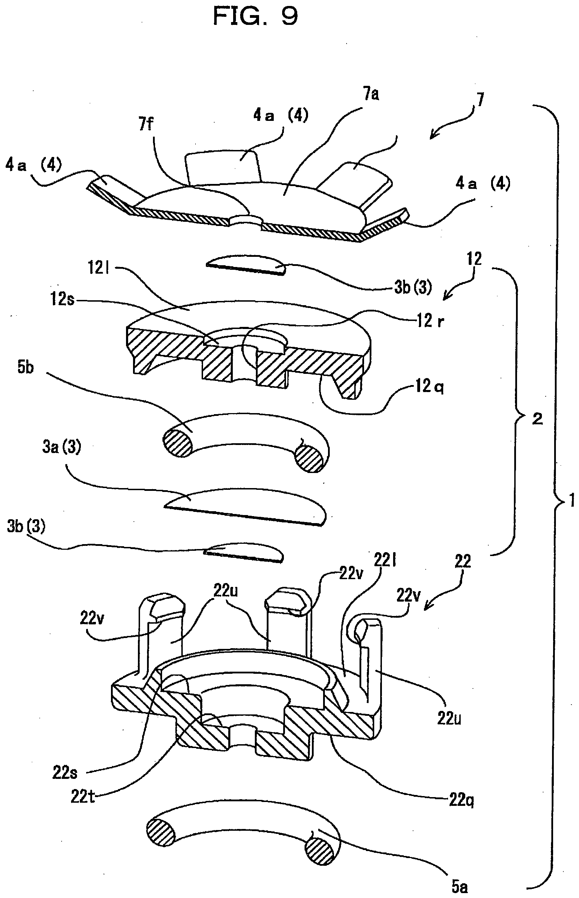

As shown in Figs. 9 to 11, the holder 2 of this embodiment is constituted by the first member 12 and the second member 22.

The first member 12 includes the top plate 121 in the form of a circular plate. A groove 12q that is annular in the circumferential direction is formed on the lower surface of the top plate 121. Further, a through hole 12r passing through the center of the top plate 121 in the thickness direction is formed. A recess is formed along the circumferential edge of the through hole 12r of the top plate 121, and the recess is formed as a first sheet mounting part 12s.

The second member 22 includes a bottom plate 221 in the form of a circular plate. A recess is formed at the center of the bottom plate 221, and the circumferential edge of the recess is formed as a second sheet mounting part 22s. Further, a through hole passing through the center of the bottom of the recess in the thickness direction is formed, and the circumferential edge of the through hole is formed as a third sheet mounting part 22t.

A plurality (6 in this embodiment) of coupling projections 22u projecting upwardly are arranged along the circumferential edge of the bottom plate 221 at equal intervals in the circumferential direction. A locking part 22v projecting inwardly (toward the center side of the bottom plate 221) is formed at the upper end of each of the coupling projections 22u.

A groove 22q is formed along the circumferential edge in the circumferential direction on the lower surface of the bottom plate 221.

In this embodiment, the selective permeable sheet 3a and a plurality (2 pieces in this embodiment) of non-selective permeable sheets 3b are mounted as the gas permeable sheet 3.

The selective permeable sheet 3a is arranged on the second sheet mounting part 22s of the bottom plate 221. One of the non-selective permeable sheets 3b is arranged on the third sheet mounting part 22t of the bottom plate 221. The other of the non-selective permeable sheets 3b is arranged on the first sheet mounting part 12s formed in the top plate 121 of the first member 12.

The elastic part 5 of this embodiment is constituted by a first rubber member 5a configured to be fitted into the groove 22q formed on the lower surface of a bottom plate 221 of the second member 22 of the holder 2, and an annular second rubber member 5b arranged between the first member 12 and the second member 22.

The second rubber member 5b is arranged on the upper surface of the circumferential edge of the selective permeable sheet 3a arranged on the second sheet mounting part 22s of the bottom plate 221, and can improve the sealing properties of the first member 12 and the second member when these members are fitted together.

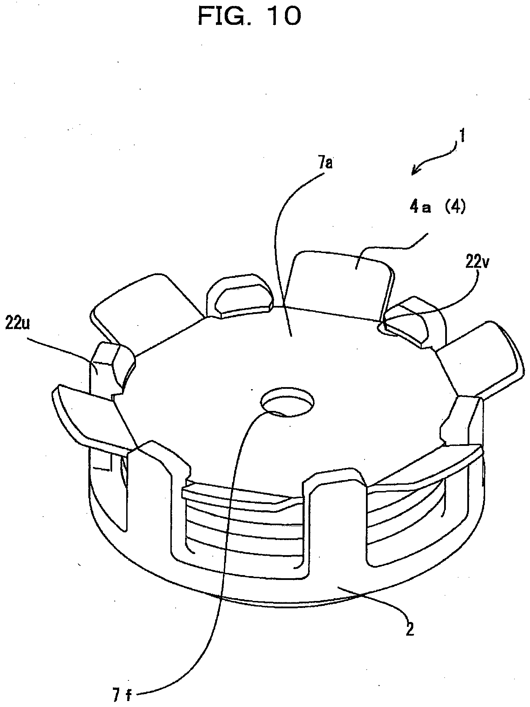

As shown in Fig. 10, the fixing plate 7a of the fixing member 7 of this embodiment is an octagonal plate body in top view, and the through hole 7f is formed at the center.

8 pressing pieces 4a projecting upwardly and obliquely outwardly from the respective sides of the fixing plate 7a are formed to constitute the pressing part 4.

The gas permeable member 1 of this embodiment is constituted by the holder 2, the fixing member 7, and the first and second rubber members 5a and 5b as described above being mounted thereon.

That is, the respective members are mounted by first arranging the respective pieces of the gas permeable sheet 3 on the first to third sheet mounting parts 12s, 22s, and 22t of the holder 2, arranging the second rubber member 5b in the groove 12q, further arranging the fixing member 7 on the upper surface of the first member 12, and then arranging the coupling projections 22u of the second member 22 on the outer circumferential edge of the first member 12, as described above.

At this time, the fixing member 7 is arranged so that the 8 pressing pieces 4a of the fixing member 7 are arranged between the coupling projections 22u of the second member 22. Further, the respective members are mounted so that the locking part 22v formed at the upper end of each of the coupling projections 22u is caught by the upper surface of the fixing plate 7a of the fixing member 7, and the fixing member 7 and the holder 2 are locked together.

That is, the fixing member 7 of this embodiment and the holder 2 are configured to be locked by the coupling projections 22u provided in the holder 2.

Accordingly, the gas permeable member 1 of this embodiment is mounted while the holder 2 and the fixing member 7 are fixed together, and therefore the fixing member 7 of this embodiment and the holder 2 are comparatively firmly mounted.

Further, the gas permeable member 1 of this embodiment is formed by fitting the first rubber member 5a into the groove 22q formed on the lower surface of the bottom plate 221 of the holder 2 (the second member 22), in the state where the fixing member 7 and the holder 2 are mounted.

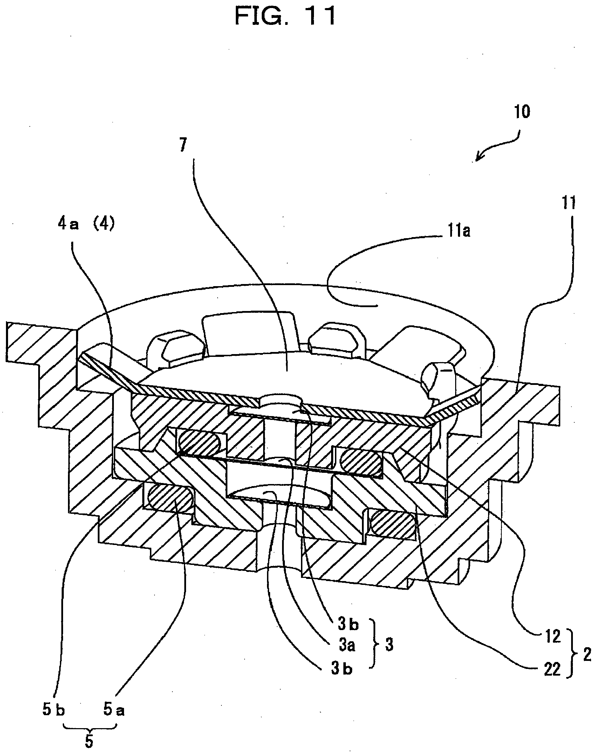

The gas permeable container 10 of this embodiment can be achieved by inserting the gas permeable member 1 of this embodiment as described above into the opening of the container body 11, as shown in Fig. 11.

In the gas permeable container 10 of this embodiment, the rubber members 5a and 5b are arranged at two places in the gas permeable member 1, and therefore the holder 2 can be more strongly biased toward the open side. Accordingly, the force of the pressing pieces 4a pressing the inner wall of the through hole 11a toward the open side is further increased, and the gas permeable member is further difficult to separate from the through hole.

The gas permeable member and the gas permeable container according to the aforementioned embodiments are as described above. However, the embodiments disclosed herein should be construed in all respects as illustrative but not limiting. The scope of the present invention is indicated by the appended claims rather than by the foregoing description, and all changes which come within the meaning and range of equivalency of the claims are therefore intended to be embraced therein.

For example, in the aforementioned embodiments, the pressing part 4 of the gas permeable member 1 is constituted by a plurality of the pressing pieces 4a in the form of plate bodies that are mounted on the outer circumference of the holder 2 or the fixing member 7 at specific intervals in the circumferential direction. However, the pressing part is not limited thereto. For example, a pressing piece may be mounted at one place on the outer circumferential surface of the holder 2 or the fixing member 7, or a pressing part may be formed continuously on the outer circumferential surface of the holder 2 or the fixing member 7 to projecting annularly.

Further, in the aforementioned embodiments, the gas permeable member includes an elastic part configured to bias the holder inside the through hole of the container body toward the open side by the recovering force due to elastic deformation, and the elastic part is constituted by a rubber member fitted into the recess at the end of the holder. However, the elastic part is not limited thereto. For example, an elastic member such as a spring may be mounted at one end of the gas permeable member (an end on the opposite side to the opening of the through hole of the container body through which the gas permeable member is inserted). Further, the elastic part may be omitted. In this case, the gas flow hole of the gas permeable member is constituted by a hole passing through the holder in one direction.

As described above, when the gas permeable member of the present invention is mounted on the container body by being inserted into the through hole of the container body through the opening of the through hole so as to allow a gas to permeate therethrough between the internal space and the outer space of the container body via the gas permeable sheet, the pressing part of the gas permeable member contacts with the inner wall of the through hole of the container body, and the pressing part presses the inner wall toward the open side at the contact position when a force is applied in the pull-out direction from the open side. Accordingly, even if a force is applied in the direction in which the gas permeable member is pulled out from the open side, the pressing part presses the inner wall of the through hole toward the open side, and therefore the pressing part can resist the force in the pull-out direction. Therefore, the gas permeable member is comparatively difficult to separate from the through hole.

Further, in the case where the pressing part is constituted by the pressing pieces with one end sides fixed to the outer surface of the holder and the other end sides configured to press the inner wall, and the pressing pieces are configured so that the other end sides are arranged more on the open side within the through hole than the one end sides, the pressing pieces can press the inner wall of the through hole toward the open side by the other end sides, and even if a force is applied in the direction in which the gas permeable member is pulled out from the opening, the pressing pieces can resist the force. Therefore, the gas permeable member is comparatively difficult to separate from the through hole.

In the case where a fixing member arranged on the open side of the holder is further provided, the pressing part is constituted by the pressing pieces with one end sides fixed to the outer surface of the fixing member and the other end sides configured to press the inner wall, and the pressing pieces are configured so that the other end sides are arranged more on the open side within the through hole than the one end sides, the fixing member is arranged on the open side of the holder, so that the pressing pieces fixed to the fixing member can press the the inner wall of the through hole toward the open side by the other end sides, and even if a force is applied in the direction in which the gas permeable member is pulled out from the opening, the pressing pieces can resist the force.

Further, when the fixing member including the pressing pieces is arranged on the open side of the holder, the pulling out of the holder from the through hole can be suppressed by the fixing member. Therefore, the gas permeable member is comparatively difficult to separate from the through hole.

In the case where the fixing member includes a locking member configured to be locked to the outer surface of the holder, the fixing member can be locked to the outer surface of the holder by the locking member, and thus the holder and the fixing member can be integrally mounted. Therefore, the fixing member and the holder that have been integrated in advance can be inserted into the through hole of the container body. Thus, the gas permeable member can be easily mounted on the container body.

In the case where the gas permeable member includes the elastic part configured to bias the holder inside the through hole toward the open side by the recovering force due to elastic deformation, the elastic part biases the holder inside the through hole toward the open side, and the force of the pressing part pressing the inner wall of the through hole toward the open side is further increased by such bias of the elastic part. Accordingly, the gas permeable member is made more difficult to separate from the through hole.

As described above, the present invention can provide a gas permeable member which can facilitate mounting of a gas permeable sheet in a container body and which is comparatively difficult to separate from the container body.

Further, the present invention can provide a gas permeable container on which a gas permeable sheet can be easily mounted and in which a gas permeable member is comparatively difficult to separate from a container body.

### REFERENCE SIGNS LIST

- 1:: Gas permeable member
- 2:: Holder
- 3:: Gas permeable sheet
- 3a:: Selective permeable sheet
- 3b:: Non-selective permeable sheet
- 4:: Pressing part
- 4a:: Pressing piece
- 5:: Rubber member
- 6:: Gas flow hole
- 7:: Fixing member
- 10:: Gas permeable container
- 11:: Container body
- 11a:: Through hole
- 11b:: Bottom
- 12, 21:: First member
- 21a:: Recess
- 22:: Second member
- 2a, 22a, 7a:: Top plate
- 22b:: Sidewall
- S:: Internal space

## Claims

1. A gas permeable member comprising:
a gas permeable sheet configured to allow a gas to permeate therethrough; and
a holder configured to hold the gas permeable sheet, wherein
the gas permeable member is mounted in a container body having a surface on which a through hole communicating with an internal space is open by being inserted through the opening, so as to allow the gas to permeate therethrough between the internal space and the outer space of the container body via the gas permeable sheet, and
the gas permeable member further comprises a pressing part that contacts with an inner wall of the through hole and that presses the inner wall toward the open side at the contact position when a force is applied in a pull-out direction from the open side.

2. The gas permeable member according to claim 1, wherein
the pressing part is constituted by a pressing piece with one end side fixed to an outer surface of the holder and the other end side configured to press the inner wall, and
the pressing piece is configured so that the other end side is arranged more on the open side within the through hole than the one end side.

3. The gas permeable member according to claim 1, further comprising:
a fixing member arranged on the open side of the holder, wherein
the pressing part is constituted by a pressing piece with one end side fixed to the outer surface of the fixing member and the other end side configured to press the inner wall, and
the pressing piece is configured so that the other end side is arranged more on the open side within the through hole than the one end side.

4. The gas permeable member according to claim 3, wherein
the fixing member comprises a locking member capable of being locked to the outer surface of the holder.

5. The gas permeable member according to any one of claims 1 to 4, further comprising:
an elastic part configured to bias the holder inside the through hole toward the open side by a recovering force due to elastic deformation.

6. A gas permeable container comprising
the gas permeable member according to any one of claims 1 to 5.
